# EUROPEAN PATENT APPLICATION

(11) **EP 1 553 637 A2**
(43) Date of publication of application: **13.07.2005**
(21) Application number: 05100040.4
(22) Date of filing: 05.01.2005
(51) Int. Cl.: H01L 31/0224, H01L 31/075

(54) **Photovoltaic device**

(30) Priority: 09.01.2004 JP 2004004574
(71) Applicant: Mitsubishi Heavy Industries, Ltd., Tokyo 108-8215 (JP)
(72) Inventor: Watanabe, Toshiya MITSUBISHI H.I., LTD., Kanazawa-ku, YOKOHAMA, Kanagawa 236-8515 (JP); Yonekura, Yoshimichi MITSUBISHI H.I., LTD., Kanazawa-ku, YOKOHAMA, Kanagawa 236-8515 (JP); Sakai, Satoshi MITSUBISHI H.I., LTD., Kanazawa-ku, YOKOHAMA, Kanagawa 236-8515 (JP); Goya, Saneyuki MITSUBISHI H.I., LTD., Kanazawa-ku, YOKOHAMA, Kanagawa 236-8515 (JP); Nakano, Youji MITSUBISHI H.I., LTD., Kanazawa-ku, YOKOHAMA, Kanagawa 236-8515 (JP); Yamashita, Nobuki MITSUBISHI H.I., LTD., Kanazawa-ku, YOKOHAMA, Kanagawa 236-8515 (JP)
(74) Representative: Jorio, Paolo, Dr. Ing.

(57) **Abstract**

A photovoltaic device is formed by depositing at least a first transparent electrode, PIN-structured or NIP-structured microcrystalline silicon layers, a second transparent electrode, and a back electrode in sequence on an electrically insulating transparent substrate. The PIN-structured or NIP-structured microcrystalline silicon layers include a p-type silicon layer, an i-type silicon layer, and an n-type silicon layer. At least one of the first transparent electrode and the second transparent electrode is a ZnO layer doped with Ga, and the Ga concentration is 15 atomic percent or less with respect to Zn.

## Description

### BACKGROUND OF THE INVENTION

### 1. FIELD OF THE INVENTION

The present invention relates to photovoltaic devices having transparent electrodes made of zinc oxide (ZnO).

### 2. DESCRIPTION OF RELATED ART

Known photovoltaic devices include silicon-based thin-film photovoltaic devices, such as solar cells. These photovoltaic devices in general include a substrate having thereon a first transparent electrode, silicon-based semiconductor layers (photovoltaic layers), a second transparent electrode, and a metal electrode film, laminated from bottom to top in that order.

These transparent electrodes must be made of materials with low resistance and high light transmittance, such as zinc oxide (ZnO) and tin oxide (SnO₂).

A low-resistance transparent electrode can be realized by adding, for example, gallium (Ga) oxide, aluminum (Al) oxide, or fluorine.

A technology in which a transparent electrode film is formed at low temperatures by adding Ga to a ZnO layer in a case where photovoltaic layers are made of amorphous silicon thin films is also known, as disclosed in Japanese Unexamined Patent Application Publication (Kokai) No. Hei 6-338623 (see paragraphs [0006] and [0014] and Fig. 1 therein).

The addition of Ga oxide or Al oxide to produce a low-resistance transparent electrode, however, results in a decrease in transmittance of the transparent electrode. Thus, addition of Ga or Al to an oxide-based transparent conductive layer causes both the resistivity and transmittance to decrease. In other words, it is difficult to achieve desired aspects of both resistivity and transmittance by adding Al or Ga.

In order to prevent the transmittance of a transparent conductive layer from decreasing as a result of Ga oxide or Al oxide being added thereto, a technique for introducing oxygen during film deposition is used to suppress oxygen deficiency in the transparent conductive layer. The introduction of oxygen, however, not only increases the resistivity of the transparent conductive layer, but also damages the transparent conductive layer itself.

The same Japanese Unexamined Patent Application Publication (Kokai) No. Hei 6-338623 introduces data indicating that the photovoltaic conversion efficiency increases when the Ga concentration in a ZnO transparent conductive layer is adjusted to 0.5 atomic percent with respect to Zn in the case of a solar cell having amorphous-silicon electricity-generating layers (Examples 4 to 6 in Table 2). This data, however, only indicates the appropriate amount of Ga to be added for the deposition of a transparent conductive layer at low temperatures. In short, the above-described Japanese Unexamined Patent Application Publication (Kokai) No. Hei 6-338623 does not examine the Ga concentration to increase the photovoltaic conversion efficiency by focusing on how the addition of Ga affects the interface between the Si layer (p layer or n layer) and the ZnO:Ga layer or the resistivity and the transmittance of the ZnO:Ga layer. Thus, there is still room for improvement of the photovoltaic conversion efficiency in photovoltaic devices.

### BRIEF SUMMARY OF THE INVENTION

The present invention was conceived in light of the above circumstances, and it is an object of the present invention to provide a photovoltaic device that realizes a high photovoltaic conversion efficiency by the use of a transparent electrode or a transparent conductive layer having an optimal relationship between the resistivity and transmittance, within a range where the quality of the interface between the Si layer (p layer or n layer) and the ZnO:Ga layer is not degraded by the addition of Ga.

In order to achieve the above-described object, a photovoltaic device according to the present invention adopts the following features.

According to one aspect of the present invention, a photovoltaic device includes an electrically insulating transparent substrate; a first transparent electrode; PIN-structured or NIP-structured microcrystalline silicon layers including a p-type silicon layer, an i-type silicon layer, and an n-type silicon layer; a second transparent electrode; and a back electrode. The first transparent electrode, the PIN-structured or NIP-structured microcrystalline silicon layers, the second transparent electrode, and the back electrode are deposited in sequence on the electrically insulating transparent substrate. At least one of the first transparent electrode and the second transparent electrode is a ZnO layer doped with Ga, and the Ga concentration is 15 atomic percent or less with respect to Zn.

This photovoltaic device receives light via the electrically insulating transparent substrate.

Adding gallium (Ga) oxide to the zinc oxide (ZnO) layer functioning as a transparent electrode causes the conductivity to increase and the transmittance to decrease. The inventors of the present invention, as a result of through investigation, have found that the photovoltaic conversion efficiency can be maintained up to a certain level (e.g., several Ω·cm) of resistivity in order to satisfy the performance requirements of the photovoltaic device. Therefore, decreasing the Ga concentration to the upper resistivity limit at which the conversion efficiency is maintained is expected to cause the conversion efficiency to increase due to an increase in the transmittance resulting from the decrease in the Ga concentration. A similar effect can also be achieved by adding oxygen to the atmosphere during sputtering instead of decreasing the Ga concentration. The process according to the present invention, however, has an advantage in that a decrease in the amount of Ga leads to an increase in the quality of the interface between the Si layer (p layer or n layer) and the ZnO:Ga layer. As a result of examining the Ga concentration from this viewpoint, it has been found that a Ga concentration of 15 atomic percent or less with respect to Zn causes the photovoltaic conversion efficiency to increase for a single photovoltaic device including microcrystalline silicon layers according to the present invention.

In this case, it is preferable that the Ga-doped ZnO layer according to the present invention be employed for the second transparent electrode adjacent to the back electrode because the ZnO layer increases reflectance.

The phrase "15 atomic percent or less" according to the present invention includes 0 atomic percent if it causes the efficiency to increase. The Ga concentration preferably ranges from 0.02 to 10 atomic percent, and more preferably from 0.5 to 2 atomic percent.

According to another aspect of the present invention, a photovoltaic device includes an electrically insulating substrate; a back electrode; a first transparent electrode; PIN-structured or NIP-structured microcrystalline silicon layers including a p-type silicon layer, an i-type silicon layer, and an n-type silicon layer; a second transparent electrode; and a collecting electrode. The back electrode, the first transparent electrode, the PIN-structured or NIP-structured microcrystalline silicon layers, the second transparent electrode, and the collecting electrode are deposited in sequence on the electrically insulating substrate. At least one of the first transparent electrode and the second transparent electrode is a ZnO layer doped with Ga, and the Ga concentration is 15 atomic percent or less with respect to Zn.

This photovoltaic device receives light via the collecting electrode.

Adding gallium (Ga) to the zinc oxide (ZnO) layer functioning as a transparent electrode causes the conductivity to increase and the transmittance to decrease. The inventors of the present invention, as a result of through investigation, have found that the photovoltaic conversion efficiency can be maintained up to a certain level (e.g., several Ω·cm) of resistivity in order to satisfy the performance requirements of the photovoltaic device. Therefore, decreasing the Ga concentration to the upper resistivity limit at which the conversion efficiency is maintained is expected to cause the conversion efficiency to increase due to an increase in the transmittance resulting from the decrease in the Ga concentration. A similar effect can also be achieved by adding oxygen to the atmosphere during sputtering instead of decreasing the Ga concentration. The process according to the present invention, however, has an advantage in that a decrease in the amount of Ga leads to an increase in the quality of the interface between the Si layer and the ZnO:Ga layer. As a result of examining the Ga concentration from this viewpoint, it has been found that a Ga concentration of 15 atomic percent or less with respect to Zn causes the photovoltaic conversion efficiency to increase for a single photovoltaic device including microcrystalline silicon layers according to the present invention.

In this case, it is preferable that the Ga-doped ZnO layer according to the present invention be employed for the first transparent electrode adjacent to the electrically insulating substrate because the ZnO layer increases reflectance.

The phrase "15 atomic percent or less" according to the present invention includes 0 atomic percent if it causes the efficiency to increase. The Ga concentration preferably ranges from 0.02 to 10 atomic percent, and more preferably from 0.5 to 2 atomic percent.

According to still another aspect of the present invention, a photovoltaic device includes an electrically insulating transparent substrate; a first transparent electrode; PIN-structured or NIP-structured amorphous silicon layers including a p-type silicon layer, an i-type silicon layer, and an n-type silicon layer; a second transparent electrode; and a back electrode. The first transparent electrode, the PIN-structured or NIP-structured amorphous silicon layers, the second transparent electrode, and the back electrode are deposited in sequence on the electrically insulating transparent substrate. At least one of the first transparent electrode and the second transparent electrode is a ZnO layer doped with Ga, and the Ga concentration is 2 atomic percent or less with respect to Zn.

This photovoltaic device receives light via the electrically insulating transparent substrate.

Adding gallium (Ga) oxide to the zinc oxide (ZnO) layer functioning as a transparent electrode causes the conductivity to increase and the transmittance to decrease. The inventors of the present invention, as a result of through investigation, have found that the photovoltaic conversion efficiency can be maintained up to a certain level (e.g., several Ω·cm) of resistivity in order to satisfy the performance requirements of the photovoltaic device. Therefore, decreasing the Ga concentration to the upper resistivity limit at which the conversion efficiency is maintained is expected to cause the conversion efficiency to increase due to an increase in the transmittance resulting from the decrease in the Ga concentration. A similar effect can also be achieved by adding oxygen to the atmosphere during sputtering instead of decreasing the Ga concentration. The process according to the present invention, however, has an advantage in that a decrease in the amount of Ga leads to an increase in the quality of the interface between the Si layer and the ZnO:Ga layer. As a result of examining the Ga concentration from this viewpoint, it has been found that a Ga concentration of 2 atomic percent or less with respect to Zn causes the photovoltaic conversion efficiency to increase for a single photovoltaic device including amorphous silicon layers according to the present invention.

In this case, it is preferable that the Ga-doped ZnO layer according to the present invention be employed for the second transparent electrode adjacent to the back electrode because the ZnO layer increases reflectance.

The phrase "2 atomic percent or less" according to the present invention includes 0 atomic percent if it causes the efficiency to increase. The Ga concentration preferably ranges from 0.02 to 1.7 atomic percent, and more preferably from 0.7 to 1.3 atomic percent.

According to still another aspect of the present invention, a photovoltaic device includes an electrically insulating substrate; a back electrode; a first transparent electrode; PIN-structured or NIP-structured amorphous silicon layers including a p-type silicon layer, an i-type silicon layer, and an n-type silicon layer; a second transparent electrode; and a collecting electrode. The back electrode, the first transparent electrode, the PIN-structured or NIP-structured amorphous silicon layers, the second transparent electrode, and the collecting electrode are deposited in sequence on the electrically insulating substrate. At least one of the first transparent electrode and the second transparent electrode is a ZnO layer doped with Ga, and the Ga concentration is 2 atomic percent or less with respect to Zn.

This photovoltaic device receives light via the collecting electrode.

Adding gallium (Ga) oxide to the zinc oxide (ZnO) layer functioning as a transparent electrode causes the conductivity to increase and the transmittance to decrease. The inventors of the present invention, as a result of through investigation, have found that the photovoltaic conversion efficiency can be maintained up to a certain level (e.g., several Ω·cm) of resistivity in order to satisfy the performance requirements of the photovoltaic device. Therefore, decreasing the Ga concentration to the upper resistivity limit at which the conversion efficiency is maintained is expected to cause the conversion efficiency to increase due to an increase in the transmittance resulting from the decrease in the Ga concentration. A similar effect can also be achieved by adding oxygen to the atmosphere during sputtering instead of decreasing the Ga concentration. The process according to the present invention, however, has an advantage in that a decrease in the amount of Ga leads to an increase in the quality of the interface between the Si layer and the ZnO:Ga layer. As a result of examining the Ga concentration from this viewpoint, it has been found that a Ga concentration of 2 atomic percent or less with respect to Zn causes the photovoltaic conversion efficiency to increase for a single photovoltaic device including amorphous silicon layers according to the present invention.

In this case, it is preferable that the Ga-doped ZnO layer according to the present invention be employed for the first transparent electrode adjacent to the electrically insulating substrate because the ZnO layer increases reflectance.

The phrase "2 atomic percent or less" according to the present invention includes 0 atomic percent if it causes the efficiency to increase. The Ga concentration preferably ranges from 0.02 to 1.7 atomic percent, and more preferably from 0.7 to 1.3 atomic percent.

The photovoltaic device according to the present invention may further include PIN-structured or NIP-structured amorphous silicon layers disposed between the first transparent electrode or the second transparent electrode and the PIN-structured or NIP-structured microcrystalline silicon layers.

The photovoltaic device with the above-described structure is a tandem photovoltaic device including microcrystalline silicon layers and amorphous silicon layers.

Also for the tandem photovoltaic device, adding gallium (Ga) to the zinc oxide (ZnO) layer functioning as a transparent electrode causes the conductivity to increase and the transmittance to decrease. The inventors of the present invention, as a result of through investigation, have found that the photovoltaic conversion efficiency can be maintained up to a certain level (e.g., several Ω·cm) of resistivity in order to satisfy the performance requirements of the photovoltaic device. Therefore, decreasing the Ga concentration to the upper resistivity limit at which the conversion efficiency is maintained is expected to cause the conversion efficiency to increase due to an increase in the transmittance resulting from the decrease in the Ga concentration. A similar effect can also be achieved by adding oxygen to the atmosphere during sputtering instead of decreasing the Ga concentration. The process according to the present invention, however, has an advantage in that a decrease in the amount of Ga leads to an increase in the quality of the interface between the Si layer and the ZnO:Ga layer. As a result of examining the Ga concentration from this viewpoint, it has been found that a Ga concentration of 15 atomic percent or less with respect to Zn causes the photovoltaic conversion efficiency to increase for a tandem photovoltaic device according to the present invention.

In this case, it is preferable that the Ga-doped ZnO layer according to the present invention be employed for the second transparent electrode adjacent to the back electrode or the first transparent electrode adjacent to the electrically insulating substrate because the ZnO layer increases reflectance.

The phrase "15 atomic percent or less" according to the present invention includes 0 atomic percent if it causes the efficiency to increase. The Ga concentration preferably ranges from 0.02 to 10 atomic percent, and more preferably from 0.5 to 2 atomic percent.

The photovoltaic device according to the present invention may further include a transparent conductive interlayer disposed between the amorphous silicon layers and the microcrystalline silicon layers. The transparent conductive interlayer is a ZnO layer doped with Ga, and the Ga concentration is 15 atomic percent or less with respect to Zn.

The transparent conductive interlayer is disposed between the microcrystalline silicon layers and the amorphous silicon layers as an interlayer, where the Ga concentration is 15 atomic percent or less. This increases the efficiency as described above.

The phrase "15 atomic percent or less" according to the present invention includes 0 atomic percent if it causes the efficiency to increase. The Ga concentration preferably ranges from 0.02 to 10 atomic percent, and more preferably from 0.5 to 2 atomic percent.

The photovoltaic device according to the present invention may further include other PIN-structured or NIP-structured microcrystalline silicon layers having a different spectral sensitivity or microcrystalline silicon germanium layers having a different spectral sensitivity disposed between the first transparent electrode or the second transparent electrode and the PIN-structured or NIP-structured microcrystalline silicon layers.

The photovoltaic device with the above-described structure is a tandem photovoltaic device including microcrystalline silicon layers and microcrystalline silicon layers with different spectral sensitivity or microcrystalline silicon germanium layers with different spectral sensitivity.

Also for the tandem photovoltaic device, adding gallium (Ga) to the zinc oxide (ZnO) layer functioning as a transparent electrode causes the conductivity to increase and the transmittance to decrease. The inventors of the present invention, as a result of through investigation, have found that the photovoltaic conversion efficiency can be maintained up to a certain level (e.g., several Ω·cm) of resistivity in order to satisfy the performance requirements of the photovoltaic device. Therefore, decreasing the Ga concentration to the upper resistivity limit at which the conversion efficiency is maintained is expected to cause the conversion efficiency to increase due to an increase in the transmittance resulting from the decrease in the Ga concentration. A similar effect can also be achieved by adding oxygen to the atmosphere during sputtering instead of decreasing the Ga concentration. The process according to the present invention, however, has an advantage in that a decrease in the amount of Ga leads to an increase in the quality of the interface between the Si layer and the ZnO:Ga layer. As a result of examining the Ga concentration from this viewpoint, it has been found that a Ga concentration of 15 atomic percent or less with respect to Zn causes the photovoltaic conversion efficiency to increase for a tandem photovoltaic device according to the present invention.

In this case, it is preferable that the Ga-doped ZnO layer according to the present invention be employed for the second transparent electrode adjacent to the back electrode or the first transparent electrode adjacent to the electrically insulating substrate because the ZnO layer increases reflectance.

The phrase "15 atomic percent or less" according to the present invention includes 0 atomic percent if it causes the efficiency to increase. The Ga concentration preferably ranges from 0.02 to 10 atomic percent, and more preferably from 0.5 to 2 atomic percent.

The photovoltaic device according to the present invention may further include a transparent conductive interlayer disposed between the microcrystalline silicon layers and the other PIN-structured or NIP-structured microcrystalline silicon layers having a different spectral sensitivity or the microcrystalline silicon germanium layers having a different spectral sensitivity. The transparent conductive interlayer is a ZnO layer doped with Ga, and the Ga concentration is 15 atomic percent or less with respect to Zn.

The transparent conductive interlayer as an interlayer is disposed between the microcrystalline silicon layers and microcrystalline silicon layers with spectral sensitivity or microcrystalline silicon germanium layers with spectral sensitivity, where the Ga concentration is 15 atomic percent or less. This increases the efficiency as described above.

The phrase "15 atomic percent or less" according to the present invention includes 0 atomic percent if it causes the efficiency to increase. The Ga concentration preferably ranges from 0.02 to 10 atomic percent, and more preferably from 0.5 to 2 atomic percent.

According to the present invention, a Ga-doped ZnO layer is used for the transparent electrodes or the transparent conductive layer, where the Ga concentration is a certain level or less with respect to Zn. More specifically, the Ga concentration is decreased to its minimum possible level, i.e., the upper resistivity limit of the transparent electrodes or the transparent conductive layer at which the desired photovoltaic conversion efficiency is maintained. Because of this, the transmittance can be prevented from being decreased, and consequently, a transparent electrode with high transmittance over a wide range of wavelengths can be produced. Thus, it is no longer necessary to add oxygen during the deposition of the ZnO layers to enhance the transmittance. This decreases the damage to the transparent electrodes by oxygen, and therefore, the controllability and yield during film deposition are enhanced.

As a result of the high transmittance achieved as described above, the photovoltaic layers can receive more intense light to increase the short-circuit current density. The photovoltaic conversion efficiency thus increases.

In addition, a decrease in the Ga concentration enhances the quality of the interface between the p-type and n-type silicon layers for high open-circuit voltage, short-circuit current density, and fill factor. This also leads to an increase in the photovoltaic conversion efficiency.

### BRIEF DESCRIPTION OF THE SEVERAL VIEWS OF THE DRAWINGS

Fig. 1 is a cross-sectional view schematically depicting a single photovoltaic device including microcrystalline-silicon electricity-generating layers according to a first embodiment of the present invention, where incident light enters via an electrically insulating transparent substrate.
Fig. 2 is a cross-sectional view schematically depicting a single photovoltaic device including microcrystalline-silicon electricity-generating layers according to a second embodiment of the present invention, where incident light enters via a collecting electrode.
Fig. 3 is a cross-sectional view schematically depicting a single photovoltaic device including amorphous-silicon electricity-generating layers according to a third embodiment of the present invention, where incident light enters via an electrically insulating transparent substrate.
Fig. 4 is a cross-sectional view schematically depicting a single photovoltaic device including amorphous-silicon electricity-generating layers according to a fourth embodiment of the present invention, where incident light enters via a collecting electrode.
Fig. 5 is a cross-sectional view schematically depicting a tandem photovoltaic device including amorphous-silicon electricity-generating layers and microcrystalline-silicon electricity-generating layers according to a fifth embodiment of the present invention, where incident light enters via an electrically insulating transparent substrate.
Fig. 6 is a cross-sectional view schematically depicting a tandem photovoltaic device according to a sixth embodiment of the present invention, where a transparent conductive interlayer is disposed between amorphous-silicon electricity-generating layers and microcrystalline-silicon electricity-generating layers.
Fig. 7 shows the relationship between the conversion efficiency of a photovoltaic device and the resistivity of a transparent electrode.

### DETAILED DESCRIPTION OF THE INVENTION

Embodiments according to the present invention will now be described with reference to the drawings.

### FIRST EMBODIMENT

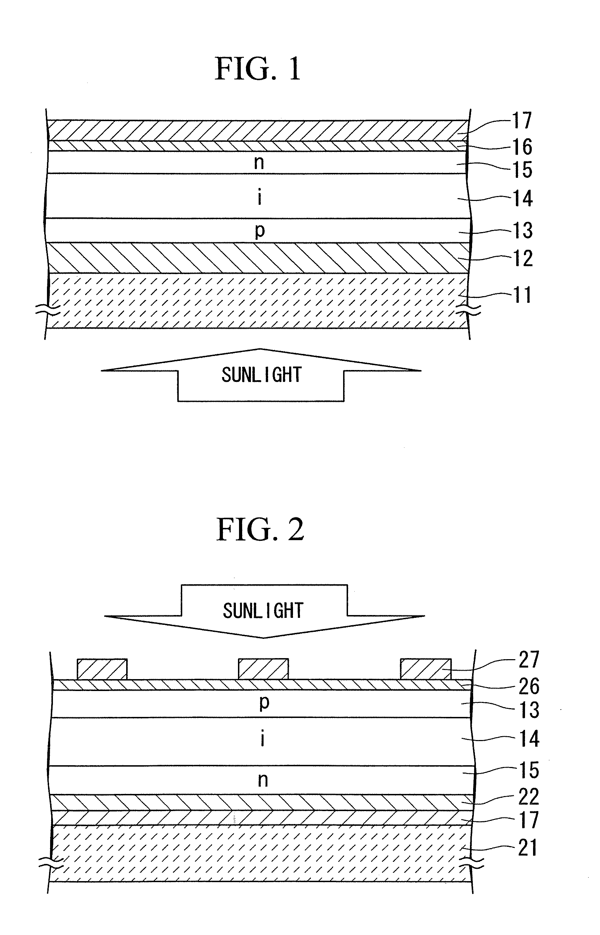

A photovoltaic device according to a first embodiment of the present invention is described with reference to Fig. 1.

The photovoltaic device according to the first embodiment includes electricity-generating layers made of microcrystalline silicon and receives incident light via an electrically insulating transparent substrate.

### First Step

A first transparent electrode 12 is formed on an electrically insulating transparent substrate 11. Optically transparent white crown glass, for example, can be used for the electrically insulating transparent substrate 11.

The first transparent electrode 12 is made of zinc oxide (ZnO) doped with gallium (Ga). Furthermore, an antireduction film may be formed on the first transparent electrode 12.

The electrically insulating transparent substrate 11 is housed in a DC sputtering apparatus, and a Ga-doped ZnO layer is formed on the transparent electrically insulating substrate 11 by evacuating the reaction chamber to a vacuum, filling the reaction chamber with a predetermined volume of argon gas, and then performing DC sputtering in this argon atmosphere. The Ga concentration is 15 atomic percent or less with respect to Zn, preferably 0.02 to 10 atomic percent, and more preferably 0.5 to 2 atomic percent.

The pressure in the DC sputtering apparatus is preferably about 0.6 Pa, the temperature of the electrically insulating transparent substrate 11 is preferably 80°C to 135°C, and the sputtering power is preferably about 100 W.

The reason that the Ga concentration has been determined as described above is given below.

When Ga is added to a transparent electrode made of ZnO, the conductivity increases, whereas the transmittance decreases. The inventors of the present invention, as a result of through investigation, have found that a drastic decrease in the resistivity is not required to increase the photovoltaic conversion efficiency; that is, the photovoltaic conversion efficiency can be increased while maintaining a certain level (e.g., several Ω·cm) of resistivity in order to satisfy the performance requirements of the photovoltaic device.

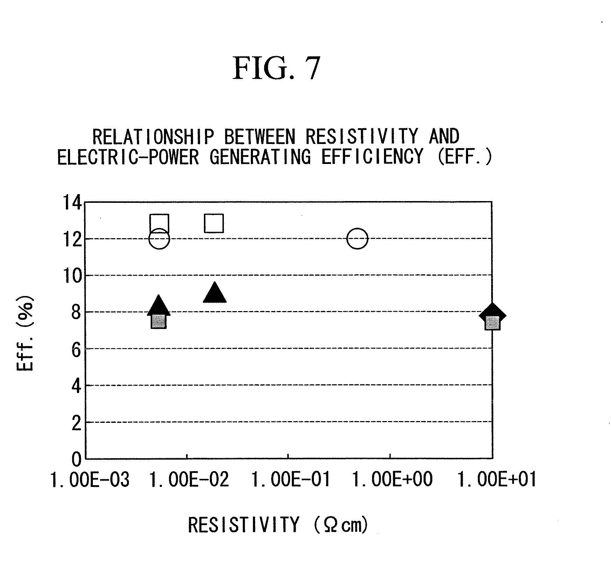

Fig. 7 shows the relationship between the resistivity of a transparent electrode (horizontal axis) and the conversion efficiency of a photovoltaic device (vertical axis). The plots in Fig. 7 represent the results for cells manufactured under the same conditions except for the Ga concentration (cells that can be compared on the basis of absolute values). As is apparent from Fig. 7, the conversion efficiency does not decrease despite the resistivity being increased to about 10 Ω·cm. Therefore, decreasing the Ga concentration to the upper resistivity limit at which the conversion efficiency is maintained is expected to cause the conversion efficiency to increase due to an increase in the transmittance.
Furthermore, a decrease in the amount of Ga leads to an increase in the quality of the interface between the Si layer and the ZnO:Ga layer. As a result of examining the Ga concentration from this viewpoint, it has been found that a Ga concentration of 15 atomic percent or less with respect to Zn causes the photovoltaic conversion efficiency to increase for a single photovoltaic device including microcrystalline-silicon electricity-generating layers according to the first embodiment. Second Step

Subsequently, while the electrically insulating transparent substrate 11 on which the first transparent electrode 12 is formed is held as a processing object on an anode of a plasma enhanced CVD apparatus, the processing object is housed in a reaction chamber, which is then evacuated to a vacuum using a vacuum pump. Then, the electricity supply to a heater incorporated in the anode is turned on, and the substrate, i.e., the processing object, is heated, for example, to 160°C or higher. SiH₄, H₂, and p-type dopant gas, which are raw material gases, are then introduced into the reaction chamber, and the pressure in the reaction chamber is regulated at a predetermined level. Then, very-high-frequency electrical power is supplied from a very-high-frequency electrical power supply to a discharge electrode to generate a plasma between the discharge electrode and the processing object, and thereby a p-type microcrystalline silicon layer 13 is formed on the first transparent electrode 12 of the processing object.

As the p-type dopant gas, B₂H₆ or the like may be used.

### Third Step

After the p-type silicon layer 13 has been formed, the electrically insulating transparent substrate 11 is housed again in a reaction chamber of another plasma enhanced CVD apparatus, and the interior of the reaction chamber is evacuated to a vacuum. A mixed gas of SiH₄ and H₂, which are raw material gases, is then introduced into the reaction chamber, and the pressure in the reaction chamber is regulated at a predetermined level. Then, very-high-frequency electrical power with a frequency of 60 MHz or higher is supplied from a very-high-frequency electrical power supply to a discharge electrode to generate a plasma between the discharge electrode and the processing object, and thereby an i-type microcrystalline silicon layer 14 is formed on the p-type silicon layer 13 of the processing object.

The pressure in the interior of the reaction chamber for generating plasma in the reaction chamber is preferably in the range of 0.5 to 10 Torr, and more preferably in the range of 1.0 to 6.0 Torr.

### Fourth Step

After the i-type silicon layer 14 is formed, introduction of the raw material gases is ceased, and the interior of the reaction chamber is evacuated to a vacuum. Then, the electrically insulating transparent substrate 11 is housed as a processing object in another reaction chamber which is evacuated to a vacuum. SiH₄, H₂, and n-type dopant gas (such as PH₃), which are raw material gases, are introduced into this reaction chamber, and the pressure in the reaction chamber is regulated at a predetermined level. Then, very-high-frequency electrical power is supplied from a very-high-frequency electrical power supply to a discharge electrode to generate a plasma between the discharge electrode and the processing object, and thereby an n-type microcrystalline silicon layer 15 is formed on the i-type silicon layer 14. The processing object is then taken out of the plasma enhanced CVD apparatus.

### Fifth Step

After the n-type silicon layer 15 is formed, introduction of the raw material gases is ceased, and the interior of the reaction chamber is evacuated to a vacuum. Then, the electrically insulating transparent substrate 11 having layers up to the n-type silicon layer 15 formed thereon is housed in the DC sputtering apparatus.

In this DC sputtering apparatus, a Ga-doped ZnO layer is formed as a second transparent electrode 16 on the n-type silicon layer 15.

After the electrically insulating transparent substrate 11 is housed in the DC sputtering apparatus, the Ga-doped ZnO layer is formed on the n-type silicon layer 15 by evacuating the reaction chamber to a vacuum, filling the reaction chamber with a predetermined volume of argon gas, and then performing DC sputtering in this argon atmosphere. The Ga concentration is 15 atomic percent or less with respect to Zn, preferably 0.02 to 10 atomic percent, and more preferably 0.5 to 2 atomic percent.

The pressure in the DC sputtering apparatus is preferably about 0.6 Pa, the temperature of the electrically insulating transparent substrate 11 is preferably 80°C to 135°C, and the sputtering power is preferably about 100 W.

### Sixth Step

Subsequently, an Ag film or Al film is formed as a back electrode 17 on the second transparent electrode 16 by, for example, sputtering or vacuum evaporation deposition.

The photovoltaic device manufactured as described above generates electricity by photovoltaic conversion from incident light, such as sunlight, entering the microcrystalline silicon layers 13, 14, and 15 with the above-described PIN structure via the electrically insulating transparent substrate 11.

In the production of the photovoltaic device, a PIN structure is constructed by forming the p-type silicon layer 13, the i-type silicon layer 14, and the n-type silicon layer 15 in sequence from the first transparent electrode 12 side; however, an NIP structure may also be constructed by forming n-type, i-type, and p-type silicon layers in sequence.

Furthermore, although ZnO layers having a Ga concentration of 15 atomic percent or less with respect to Zn are used for both the first transparent electrode 12 and the second transparent electrode 16 in the first embodiment, the present invention is not limited to this structure. Such a ZnO layer may be used for either the first transparent electrode 12 or the second transparent electrode 16.

In this case, however, it is preferable that a Ga-doped ZnO layer according to the present invention be employed for the second transparent electrode 16 adjacent to the back electrode 17 because a transparent electrode here increases the reflectance.

According to the first embodiment, Ga-doped ZnO layers are used for the transparent electrodes 12 and 16, where the Ga concentration is 15 atomic percent or less with respect to Zn. More specifically, the Ga concentration is decreased to its minimum possible level, i.e., the upper resistivity limit at which the desired photovoltaic conversion efficiency is maintained. Because of this, the transmittance can be prevented from being decreased, and consequently, a transparent electrode with high transmittance over a wide range of wavelengths can be produced. Thus, it is no longer necessary to add oxygen during the deposition of the ZnO layers to enhance the transmittance. This decreases the damage to the transparent electrodes by oxygen, and therefore, the controllability and yield during film deposition are enhanced.

As a result of the high transmittance achieved as described above, the photovoltaic layers can receive more intense light to increase the short-circuit current density. The photovoltaic conversion efficiency thus increases.

In addition, a decrease in the Ga concentration enhances the quality of the interface between the p-type and n-type silicon layers for high open-circuit voltage, short-circuit current density, and fill factor. This also leads to an increase in the photovoltaic conversion efficiency.

### SECOND EMBODIMENT

A photovoltaic device according to a second embodiment of the present invention is described with reference to Fig. 2.

The photovoltaic device according to the second embodiment is similar to the photovoltaic device according to the first embodiment in that electricity-generating layers are made of microcrystalline silicon. Unlike the photovoltaic device according to the first embodiment, the photovoltaic device according to the second embodiment is constructed so as to receive incident light via an opposite collecting electrode to enable an electrically insulating opaque substrate to be used.

### First Step

A back electrode 17 and a first transparent electrode 22 are formed on an electrically insulating opaque substrate 21 that does not transmit light. A stainless steel plate, for example, is used as the electrically insulating opaque substrate 21. Soda-lime glass may be used in place of the electrically insulating opaque substrate 21.

For example, Ag or Al is used for the back electrode 17. In the same manner as with the first embodiment, zinc oxide (ZnO) doped with gallium (Ga) is used for the first transparent electrode 22, where the Ga concentration is 15 atomic percent or less with respect to Zn, preferably 0.02 to 10 atomic percent, and more preferably 0.5 to 2 atomic percent. The process for forming this Ga-doped ZnO layer and the reason for the Ga concentration determined thus have been described in the first embodiment. Furthermore, an antireduction film may be formed on the first transparent electrode 22.

### Second Step to Fourth Step

In the second step to the fourth step, an n-type microcrystalline silicon layer 15, an i-type microcrystalline silicon layer 14, and a p-type microcrystalline silicon layer 13 are formed in the same manner as in the first embodiment.

### Fifth Step

After the p-type silicon layer 13 is formed, introduction of the raw material gases is ceased, and the interior of the reaction chamber is evacuated to a vacuum. Then, the electrically insulating opaque substrate 21 having layers up to the p-type silicon layer 13 formed thereon is housed in the DC sputtering apparatus.

In the same manner as with the first embodiment, a Ga-doped ZnO layer is formed as a second transparent electrode 26 in this DC sputtering apparatus, where the Ga concentration is 15 atomic percent or less with respect to Zn, preferably 0.02 to 10 atomic percent, and more preferably 0.5 to 2 atomic percent.

### Sixth Step

Subsequently, an Ag film or Al film is formed as a collecting electrode 27 on the second transparent electrode 26. The collecting electrode 27 is formed in a mesh or stripes so as not to block the incident light.

The photovoltaic device manufactured as described above generates electricity by photovoltaic conversion from incident light, such as sunlight, entering the microcrystalline silicon layers 15, 14, and 13 with the above-described NIP structure via the collecting electrode 27.

In the production of the photovoltaic device, an NIP structure is constructed by forming the n-type silicon layer 15, the i-type silicon layer 14, and the p-type silicon layer 13 in sequence from the first transparent electrode 22 side; however, a PIN structure may also be constructed by forming the p-type, i-type, and n-type silicon layers in sequence.

Furthermore, although ZnO layers having a Ga concentration of 15 atomic percent or less with respect to Zn are used for both the first transparent electrode 22 and the second transparent electrode 26 in the second embodiment, the present invention is not limited to this structure. Such a ZnO layer may be used for either the first transparent electrode 22 or the second transparent electrode 26.

In this case, however, it is preferable that a Ga-doped ZnO layer according to the present invention be employed for the first transparent electrode 22 adjacent to the electrically insulating opaque substrate 21 because a transparent electrode here increases the reflectance.

According to the second embodiment, Ga-doped ZnO layers are used for the transparent electrodes 22 and 26, where the Ga concentration is 15 atomic percent or less with respect to Zn. More specifically, the Ga concentration is decreased to its minimum possible level, i.e., the upper resistivity limit at which the desired photovoltaic conversion efficiency is maintained. Because of this, the transmittance can be prevented from being decreased, and consequently, a transparent electrode with high transmittance over a wide range of wavelengths can be produced. Thus, it is no longer necessary to add oxygen during the deposition of the ZnO layers to enhance the transmittance. This decreases the damage to the transparent electrodes by oxygen, and therefore, the controllability and yield during film deposition are enhanced.

As a result of the high transmittance achieved as described above, the photovoltaic layers can receive more intense light to increase the short-circuit current density. The photovoltaic conversion efficiency thus increases.

In addition, a decrease in the Ga concentration enhances the quality of the interface between the p-type and n-type silicon layers for high open-circuit voltage, short-circuit current density, and fill factor. This also leads to an increase in the photovoltaic conversion efficiency.

### THIRD EMBODIMENT

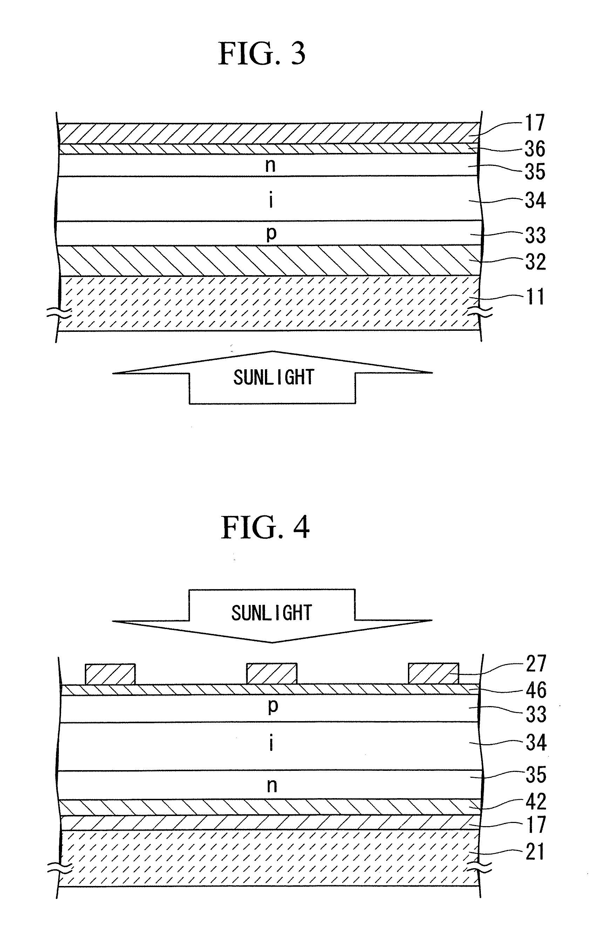

A photovoltaic device according to a third embodiment of the present invention is described with reference to Fig. 3.

Unlike the photovoltaic devices according to the first and second embodiments, the photovoltaic device according to the third embodiment has electricity-generating layers made of amorphous silicon. The photovoltaic device according to the third embodiment receives incident light via an electrically insulating transparent substrate in the same manner as with the first embodiment.

### First Step

A first transparent electrode 32 is formed on an electrically insulating transparent substrate 11. Optically transparent white crown glass, for example, can be used for the electrically insulating transparent substrate 11.

The first transparent electrode 32 is made of tin oxide (SnO₂).

The electrically insulating transparent substrate 11 is housed in an atmospheric plasma enhanced CVD apparatus, and the first transparent electrode 32 made of SnO₂ is formed on the electrically insulating transparent substrate 11 from SnCl₄, water vapor (H₂O), and anhydrous hydrogen fluoride (HF) which are raw material gases.

### Second Step

Subsequently, while the electrically insulating transparent substrate 11 on which the first transparent electrode 32 is formed is held as a processing object on an anode of a plasma enhanced CVD apparatus, the processing object is housed in a reaction chamber, which is then evacuated to a vacuum using a vacuum pump. Then, the electricity supply to a heater incorporated in the anode is turned on, and the substrate, i.e., the processing object, is heated, for example, to 160°C or higher. SiH₄, H₂, and p-type dopant gas, which are raw material gases, are then introduced into the reaction chamber, and the pressure in the reaction chamber is regulated at a predetermined level. Then, RF electrical power is supplied from an RF electrical power supply to a discharge electrode to generate a plasma between the discharge electrode and the processing object, and thereby a p-type amorphous silicon layer 33 is formed on the first transparent electrode 32 of the processing object. The amorphous silicon layer 33 is formed mainly by lowering the dilution ratio of silane to hydrogen compared with that according to the first embodiment. A lower dilution ratio of silane to hydrogen is also used in the third step and the fourth step.

As the p-type dopant gas, B₂H₆ or the like may be used.

### Third Step

After the p-type silicon layer 33 has been formed, the electrically insulating transparent substrate 11 is housed again in a reaction chamber of another plasma enhanced CVD apparatus, and the interior of the reaction chamber is evacuated to a vacuum. A mixed gas of SiH₄ and H₂, which are raw material gases, is then introduced into the reaction chamber, and the pressure in the reaction chamber is regulated at a predetermined level. Then, very-high-frequency electrical power with a frequency of 60 MHz or higher is supplied from a very-high-frequency electrical power supply to a discharge electrode to generate a plasma between the discharge electrode and the processing object, and thereby an i-type amorphous silicon layer 34 is formed on the p-type silicon layer 33 of the processing object.

The pressure in the interior of the reaction chamber for generating plasma in the reaction chamber is preferably in the range of 0.5 to 10 Torr, and more preferably in the range of 0.5 to 6.0 Torr.

### Fourth Step

After the i-type silicon layer 34 is formed, introduction of the raw material gases is ceased, and the interior of the reaction chamber is evacuated to a vacuum. Then, the electrically insulating transparent substrate 11 is housed as a processing object in another reaction chamber, which is evacuated to a vacuum. SiH₄, H₂, and n-type dopant gas (such as PH₃), which are raw material gases, are introduced into this reaction chamber, and the pressure in the reaction chamber is regulated at a predetermined level. Then, very-high-frequency electrical power is supplied from a very-high-frequency electrical power supply to a discharge electrode to generate a plasma between the discharge electrode and the processing object, and thereby an n-type amorphous silicon layer 35 is formed on the i-type silicon layer 34. The processing object is then taken out of the plasma enhanced CVD apparatus.

### Fifth Step

After the n-type silicon layer 35 is formed, introduction of the raw material gases is ceased, and the interior of the reaction chamber is evacuated to a vacuum. Then, the electrically insulating transparent substrate 11 having layers up to the n-type silicon layer 35 formed thereon is housed in the DC sputtering apparatus.

In this DC sputtering apparatus, a Ga-doped ZnO layer is formed as a second transparent electrode 36 on the n-type silicon layer 35.

After the electrically insulating transparent substrate 11 is housed in the DC sputtering apparatus, the Ga-doped ZnO layer is formed on the n-type silicon layer 35 by evacuating the reaction chamber to a vacuum, filling the reaction chamber with a predetermined volume of argon gas, and then performing DC sputtering in this argon atmosphere. The Ga concentration is 2 atomic percent or less with respect to Zn, preferably 0.02 to 1.7 atomic percent, and more preferably 0.7 to 1.3 atomic percent.

The pressure in the DC sputtering apparatus is preferably about 0.6 Pa, the temperature of the electrically insulating transparent substrate 11 is preferably 80°C to 135°C, and the sputtering power is preferably about 100 W.

The Ga concentration is determined thus for the same reason as described with reference to Fig. 7 in the first embodiment. More specifically, decreasing the Ga concentration to the upper resistivity limit at which the conversion efficiency of the photovoltaic device is maintained is expected to cause the conversion efficiency to increase due to an increase in the transmittance. Furthermore, a decrease in the amount of Ga leads to an increase in the quality of the interface between the Si layer (p-layer or n-layer) and the ZnO:Ga layer. As a result of examining the Ga concentration from this viewpoint, it has been found that a Ga concentration of 2 atomic percent or less with respect to Zn causes the photovoltaic conversion efficiency to increase for a single photovoltaic device including amorphous-silicon electricity-generating layers according to the third embodiment.

### Sixth Step

Subsequently, an Ag film or Al film is formed as a back electrode 17 on the second transparent electrode 36.

The photovoltaic device manufactured as described above generates electricity by photovoltaic conversion from incident light, such as sunlight, entering the amorphous silicon layers 33, 34, and 35 with the above-described PIN structure via the electrically insulating transparent substrate 11.

In the production of the photovoltaic device, a PIN structure is constructed by forming the p-type silicon layer 33, the i-type silicon layer 34, and the n-type silicon layer 35 in sequence from the first transparent electrode 32 side; however, an NIP structure may also be constructed by forming n-type, i-type, and p-type silicon layers in sequence.

Furthermore, although a ZnO layer having a Ga concentration of 2 atomic percent or less with respect to Zn is used for the second transparent electrode 36 in the third embodiment, the present invention is not limited to this structure. Such a ZnO layer may be used for the first transparent electrode 32.

In this case, however, it is preferable that a Ga-doped ZnO layer according to the present invention be employed for the second transparent electrode 36 adjacent to the back electrode 37 because a transparent electrode here increases the reflectance.

According to the third embodiment, a Ga-doped ZnO layer is used for the second transparent electrode 36, where the Ga concentration is 2 atomic percent or less with respect to Zn. More specifically, the Ga concentration is decreased to its minimum possible level, i.e., the upper resistivity limit at which the desired photovoltaic conversion efficiency is maintained. Because of this, the transmittance can be prevented from being decreased, and consequently, a transparent electrode with high transmittance over a wide range of wavelengths can be produced. Thus, it is no longer necessary to add oxygen during the deposition of the ZnO layer to enhance the transmittance. This decreases the damage to the transparent electrode by oxygen, and therefore, the controllability and yield during film deposition are enhanced.

As a result of the high transmittance achieved as described above, the photovoltaic layers can receive more intense light to increase the short-circuit current density. The photovoltaic conversion efficiency thus increases.

In addition, a decrease in the Ga concentration enhances the quality of the interface between the p-type and n-type silicon layers for high open-circuit voltage, short-circuit current density, and fill factor. This also leads to an increase in the photovoltaic conversion efficiency.

### FOURTH EMBODIMENT

A photovoltaic device according to a fourth embodiment of the present invention is described with reference to Fig. 4.

The photovoltaic device according to the fourth embodiment is similar to the photovoltaic device according to the third embodiment in that electricity-generating layers are made of amorphous silicon. Unlike the photovoltaic device according to the third embodiment and just like the photovoltaic device according to the second embodiment, the photovoltaic device according to the fourth embodiment is constructed so as to receive incident light via a collecting electrode opposite to an electrically insulating opaque substrate to enable an electrically insulating opaque substrate to be used.

### First Step

A back electrode 17 and a first transparent electrode 42 are formed on an electrically insulating opaque substrate 21 that does not transmit light. A stainless steel plate, for example, is used as the electrically insulating opaque substrate 21. Soda-lime glass may be used in place of the electrically insulating opaque substrate 21.

The first transparent electrode 42 is made of zinc oxide (ZnO) doped with gallium (Ga).

The electrically insulating opaque substrate 21 is housed in a DC sputtering apparatus, and a Ga-doped ZnO layer is formed on the electrically insulating opaque substrate 21 by evacuating the reaction chamber to a vacuum, filling the reaction chamber with a predetermined volume of argon gas, and then performing DC sputtering in this argon atmosphere. The Ga concentration is 2 atomic percent or less with respect to Zn, preferably 0.02 to 1.7 atomic percent, and more preferably 0.7 to 1.3 atomic percent. The Ga concentration is determined thus for the same reason as described in the third embodiment.

The pressure in the DC sputtering apparatus is preferably about 0.6 Pa, the temperature of the electrically insulating opaque substrate 21 is preferably 80°C to 135°C, and the sputtering power is preferably about 100 W.

### Second Step to Fourth Step

In the second step to the fourth step, an n-type amorphous silicon layer 35, an i-type amorphous silicon layer 34, and a p-type amorphous silicon layer 33 are formed in the same manner as in the third embodiment.

### Fifth Step

After the p-type silicon layer 33 is formed, introduction of the raw material gases is ceased, and the interior of the reaction chamber is evacuated to a vacuum. Then, the electrically insulating opaque substrate 21 having layers up to the p-type silicon layer 33 formed thereon is housed in the DC sputtering apparatus.

In this DC sputtering apparatus, a SnO₂ layer is formed as a second transparent electrode 46.

### Sixth Step

Subsequently, an Ag film or Al film is formed as a collecting electrode 27 on the second transparent electrode 46. The collecting electrode 27 is formed in a mesh or stripes so as not to block the incident light.

The photovoltaic device manufactured as described above generates electricity by photovoltaic conversion from incident light, such as sunlight, entering the amorphous silicon layers 35, 34, and 33 with the above-described NIP structure via the collecting electrode 27.

In the production of the photovoltaic device, an NIP structure is constructed by forming the n-type silicon layer 35, the i-type silicon layer 34, and the p-type silicon layer 33 in sequence from the first transparent electrode 42 side; however, a PIN structure may also be constructed by forming the p-type, i-type, and n-type silicon layers in sequence.

Furthermore, although a ZnO layer having a Ga concentration of 2 atomic percent or less with respect to Zn is used for the first transparent electrode 42 in the fourth embodiment, the present invention is not limited to this structure. Such a ZnO layer may be used for the second transparent electrode 46.

In this case, however, it is preferable that a Ga-doped ZnO layer according to the present invention be employed for the first transparent electrode 42 adjacent to the electrically insulating opaque substrate 21 because a transparent electrode here increases the reflectance.

According to the fourth embodiment, a Ga-doped ZnO layer is used for the transparent electrode 42, where the Ga concentration is 2 atomic percent or less with respect to Zn. More specifically, the Ga concentration is decreased to its minimum possible level, i.e., the upper resistivity limit at which the desired photovoltaic conversion efficiency is maintained. Because of this, the transmittance can be prevented from being decreased, and consequently, a transparent electrode with high transmittance over a wide range of wavelengths can be produced. Thus, it is no longer necessary to add oxygen during the deposition of the ZnO layer to enhance the transmittance. This decreases the damage to the transparent electrode by oxygen, and therefore, the controllability and yield during film deposition are enhanced.

As a result of the high transmittance achieved as described above, the photovoltaic layers can receive more intense light to increase the short-circuit current density. The photovoltaic conversion efficiency thus increases.

In addition, a decrease in the Ga concentration enhances the quality of the interface between the p-type and n-type silicon layers for high open-circuit voltage, short-circuit current density, and fill factor. This also leads to an increase in the photovoltaic conversion efficiency.

### FIFTH EMBODIMENT

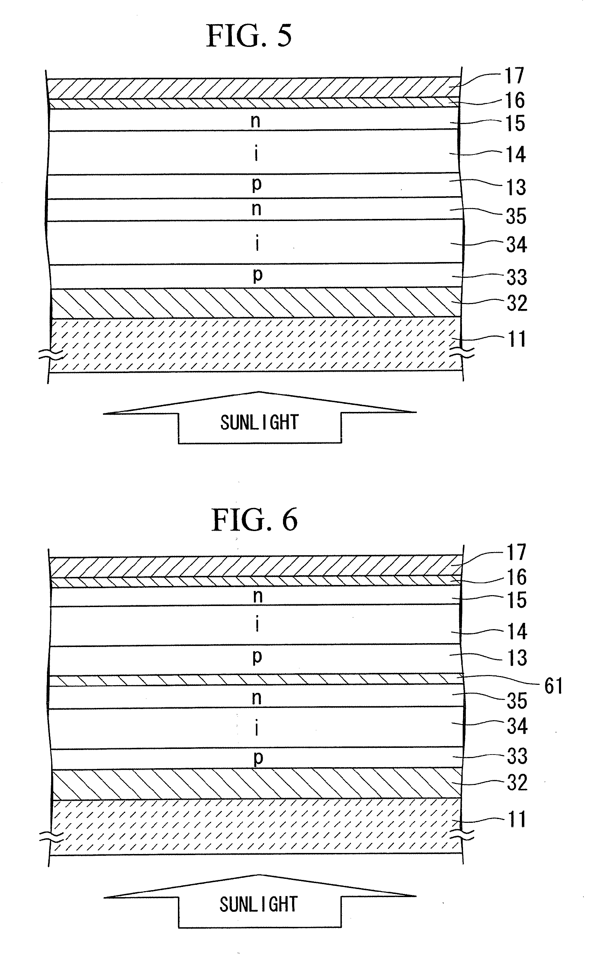

A photovoltaic device according to a fifth embodiment of the present invention is described with reference to Fig. 5.

The photovoltaic device according to the fifth embodiment differs from those according to the first to the fourth embodiments in that the photovoltaic device according to the fifth embodiment is a tandem photovoltaic device including electricity-generating layers made of amorphous silicon and electricity-generating layers made of microcrystalline silicon.

### First Step

A first transparent electrode 32 is formed on an electrically insulating transparent substrate 11. Optically transparent white crown glass, for example, can be used for the electrically insulating transparent substrate 11.

The first transparent electrode 32 is made of tin oxide (SnO₂).

The electrically insulating transparent substrate 11 is housed in an atmospheric plasma enhanced CVD apparatus, and the first transparent electrode 32 made of SnO₂ is formed on the electrically insulating transparent substrate 11 from SnCl₄, water vapor (H₂O), and anhydrous hydrogen fluoride (HF), which are raw material gases.

### Second Step

Subsequently, while the electrically insulating transparent substrate 11 on which the first transparent electrode 32 is formed is held as a processing object on an anode of a plasma enhanced CVD apparatus, the processing object is housed in a reaction chamber, which is then evacuated to a vacuum using a vacuum pump. Then, the electricity supply to a heater incorporated in the anode is turned on, and the substrate, i.e., the processing object, is heated, for example, to 160°C or higher. SiH₄, H₂, and p-type dopant gas, which are raw material gases, are then introduced into the reaction chamber, and the pressure in the reaction chamber is regulated at a predetermined level. Then, RF electrical power is supplied from an RF electrical power supply to a discharge electrode to generate a plasma between the discharge electrode and the processing object, and thereby a p-type amorphous silicon layer 33 is formed on the first transparent electrode 32 of the processing object. The amorphous silicon layer 33 is formed mainly by lowering the dilution ratio of silane to hydrogen compared with that according to the first embodiment. A lower dilution ratio of silane to hydrogen is also used in the third step and the fourth step.

As the p-type dopant gas, B₂H₆ or the like may be used.

### Third Step

After the p-type silicon layer 33 has been formed, the electrically insulating transparent substrate 11 is housed again in a reaction chamber of another plasma enhanced CVD apparatus, and the interior of the reaction chamber is evacuated to a vacuum. A mixed gas of SiH₄ and H₂, which are raw material gases, is then introduced into the reaction chamber, and the pressure in the reaction chamber is regulated at a predetermined level. Then, very-high-frequency electrical power with a frequency of 60 MHz or higher is supplied from a very-high-frequency electrical power supply to a discharge electrode to generate a plasma between the discharge electrode and the processing object, and thereby an i-type amorphous silicon layer 34 is formed on the p-type silicon layer 33 of the processing object.

The pressure in the interior of the reaction chamber for generating plasma in the reaction chamber is preferably in the range of 0.5 to 10 Torr, and more preferably in the range of 0.5 to 6.0 Torr.

### Fourth Step

After the i-type silicon layer 34 is formed, introduction of the raw material gases is ceased, and the interior of the reaction chamber is evacuated to a vacuum. Then, the electrically insulating transparent substrate 11 is housed as a processing object in another reaction chamber which is evacuated to a vacuum. SiH₄, H₂, and n-type dopant gas (such as PH₃), which are raw material gases, are introduced into this reaction chamber, and the pressure in the reaction chamber is regulated at a predetermined level. Then, very-high-frequency electrical power is supplied from a very-high-frequency electrical power supply to a discharge electrode to generate a plasma between the discharge electrode and the processing object, and thereby an n-type amorphous silicon layer 35 is formed on the i-type silicon layer 34. The processing object is then taken out of the plasma enhanced CVD apparatus.

As a result of the processing from the second step to the fourth step, electricity-generating layers made of amorphous silicon are formed.

### Fifth Step

Next, electricity-generating layers made of microcrystalline silicon are formed on the above-described amorphous-silicon electricity-generating layers 33, 34, and 35.

The microcrystalline silicon layers can be formed in the same manner as in the first embodiment.

More specifically, while the electrically insulating transparent substrate 11 on which the amorphous silicon layers 33, 34, and 35 are formed is held as a processing object on an anode of a plasma enhanced CVD apparatus, the processing object is housed in a reaction chamber, which is then evacuated to a vacuum using a vacuum pump. Then, the electricity supply to a heater incorporated in the anode is turned on, and the substrate, i.e., the processing object, is heated, for example, to 160°C or higher. SiH₄, H₂, and p-type dopant gas, which are raw material gases, are then introduced into the reaction chamber, and the pressure in the reaction chamber is regulated at a predetermined level. Then, very-high-frequency electrical power is supplied from a very-high-frequency electrical power supply to a discharge electrode to generate a plasma between the discharge electrode and the processing object, and thereby a p-type microcrystalline silicon layer 13 is formed on the amorphous-silicon electricity-generating layer 35 of the processing object.

As the p-type dopant gas, B₂H₆ or the like may be used.

### Sixth Step

After the p-type silicon layer 13 has been formed, the electrically insulating transparent substrate 11 is housed again in a reaction chamber of another plasma enhanced CVD apparatus, and the interior of the reaction chamber is evacuated to a vacuum. A mixed gas of SiH₄ and H₂, which are raw material gases, is then introduced into the reaction chamber, and the pressure in the reaction chamber is regulated at a predetermined level. Then, very-high-frequency electrical power with a frequency of 60 MHz or higher is supplied from a very-high-frequency electrical power supply to a discharge electrode to generate a plasma between the discharge electrode and the processing object, and thereby an i-type microcrystalline silicon layer 14 is formed on the p-type silicon layer 13 of the processing object.

The pressure in the interior of the reaction chamber for generating plasma in the reaction chamber is preferably in the range of 0.5 to 10 Torr, and more preferably in the range of 1.0 to 6.0 Torr.

### Seventh Step

After the i-type silicon layer 14 is formed, introduction of the raw material gases is ceased, and the interior of the reaction chamber is evacuated to a vacuum. Then, the electrically insulating transparent substrate 11 is housed as a processing object in another reaction chamber, which is evacuated to a vacuum. SiH₄, H₂, and n-type dopant gas (such as PH₃), which are raw material gases, are introduced into this reaction chamber, and the pressure in the reaction chamber is regulated at a predetermined level. Then, very-high-frequency electrical power is supplied from a very-high-frequency electrical power supply to a discharge electrode to generate a plasma between the discharge electrode and the processing object, and thereby an n-type microcrystalline silicon layer 15 is formed on the i-type silicon layer 14. The processing object is then taken out of the plasma enhanced CVD apparatus.

### Eighth Step

After the n-type microcrystalline silicon layer 15 is formed, introduction of the raw material gases is ceased, and the interior of the reaction chamber is evacuated to a vacuum. Then, the electrically insulating transparent substrate 11 having layers up to the n-type silicon layer 15 formed thereon is housed in the DC sputtering apparatus.

In this DC sputtering apparatus, a Ga-doped ZnO layer is formed as a second transparent electrode 16 on the n-type silicon layer 15.

After the electrically insulating transparent substrate 11 is housed in the DC sputtering apparatus, the Ga-doped ZnO layer is formed on the n-type silicon layer 15 by evacuating the reaction chamber to a vacuum, filling the reaction chamber with a predetermined volume of argon gas, and then performing DC sputtering in this argon atmosphere. The Ga concentration is 15 atomic percent or less with respect to Zn, preferably 0.02 to 10 atomic percent, and more preferably 0.5 to 2 atomic percent. The Ga concentration is determined thus for the same reason as described in the first embodiment.

The pressure in the DC sputtering apparatus is preferably about 0.6 Pa, the temperature of the electrically insulating transparent substrate 11 is preferably 80°C to 135°C, and the sputtering power is preferably about 100 W.

### Ninth Step

Subsequently, an Ag film or Al film is formed as a back electrode 17 on the second transparent electrode 16.

The photovoltaic device manufactured as described above generates electricity by photovoltaic conversion from incident light, such as sunlight, entering the microcrystalline silicon layers 13, 14, and 15 with the above-described PIN structure via the electrically insulating transparent substrate 11.

In the production of the photovoltaic device, a PIN structure is constructed by forming the p-type amorphous silicon layer 33, the i-type amorphous silicon layer 34, and the n-type amorphous silicon layer 35 in sequence from the first transparent electrode 32 side; however, an NIP structure may also be constructed by forming the n-type, i-type, and p-type amorphous silicon layers in sequence.

In the production of the photovoltaic device, a PIN structure is constructed by forming the p-type microcrystalline silicon layer 13, the i-type microcrystalline silicon layer 14, and the n-type microcrystalline silicon layer 15 in sequence from the first transparent electrode 32 side; however, an NIP structure may also be constructed by forming the n-type, i-type, and p-type microcrystalline silicon layers in sequence.

Furthermore, the amorphous-silicon electricity-generating layers 33, 34, and 35 may be formed on the microcrystalline-silicon electricity-generating layers 13, 14, and 15.

In addition, the photovoltaic device may be constructed such that the electrically insulating opaque substrate 21 is used in place of the electrically insulating transparent substrate 11 and the collecting electrode 27 is used in place of the back electrode 17 to receive incident light via the collecting electrode 27, as with the second or fourth embodiment.

Furthermore, although a ZnO layer having a Ga concentration of 15 atomic percent or less with respect to Zn is used for the second transparent electrode 16 in the third embodiment, the present invention is not limited to this structure. Such a ZnO layer may be used for the first transparent electrode 32.

In this case, however, it is preferable that a Ga-doped ZnO layer according to the present invention be employed for the second transparent electrode 16 adjacent to the back electrode 17 because a transparent electrode here increases the reflectance.

According to the fifth embodiment, a Ga-doped ZnO layer is used for the transparent electrode 16, where the Ga concentration is 15 atomic percent or less with respect to Zn. More specifically, the Ga concentration is decreased to its minimum possible level, i.e., the upper resistivity limit at which the desired photovoltaic conversion efficiency is maintained. Because of this, the transmittance can be prevented from being decreased, and consequently, a transparent electrode with high transmittance over a wide range of wavelengths can be produced. Thus, it is no longer necessary to add oxygen during the deposition of the ZnO layer to enhance the transmittance. This decreases the damage to the transparent electrode by oxygen, and therefore, the controllability and yield during film deposition are enhanced.

As a result of the high transmittance achieved as described above, the photovoltaic layers can receive more intense light to increase the short-circuit current density. The photovoltaic conversion efficiency thus increases.

In addition, a decrease in the Ga concentration enhances the quality of the interface between the p-type and n-type silicon layers for high open-circuit voltage, short-circuit current density, and fill factor. This also leads to an increase in the photovoltaic conversion efficiency.

The tandem photovoltaic device according to the fifth embodiment includes electricity-generating layers made of amorphous silicon and electricity-generating layers made of microcrystalline silicon. Alternatively, the tandem photovoltaic device according to the present invention may include electricity-generating layers made of one type of microcrystalline silicon and electricity-generating layers made of another type of microcrystalline silicon with different spectral sensitivities. Furthermore, the tandem photovoltaic device according to the present invention may include electricity-generating layers made of microcrystalline silicon and electricity-generating layers made of microcrystalline silicon germanium with different spectral sensitivities.

Microcrystalline silicon germanium can be produced from SiH₄, GeH₄, and H₂ serving as raw materials in the same manner as for microcrystalline silicon.

### SIXTH EMBODIMENT

A photovoltaic device according to a sixth embodiment of the present invention is described with reference to Fig. 6.

The photovoltaic device according to the sixth embodiment is similar to the photovoltaic device according to the fifth embodiment in that both photovoltaic devices are tandem photovoltaic devices including electricity-generating layers made of amorphous silicon and electricity-generating layers made of microcrystalline silicon. The photovoltaic device according to the sixth embodiment differs from the photovoltaic device according to the fifth embodiment in that the photovoltaic device according to the sixth embodiment includes a transparent conductive interlayer between the amorphous-silicon electricity-generating layers 33 to 35 and the microcrystalline-silicon electricity-generating layers 13 to 15. The following description focuses on this difference.

After the n-type amorphous silicon layer 35 has been formed in the fourth step of the fifth embodiment, a transparent conductive interlayer 61 is formed of Ga-doped ZnO with a DC sputtering apparatus.

In this DC sputtering apparatus, a Ga-doped ZnO layer is formed as the transparent conductive interlayer 61 on the n-type amorphous silicon layer 35.

After the electrically insulating transparent substrate 11 is housed in the DC sputtering apparatus, the Ga-doped ZnO layer is formed on the n-type silicon layer 35 by evacuating the reaction chamber to a vacuum, filling the reaction chamber with a predetermined volume of argon gas, and then performing DC sputtering in this argon atmosphere. The Ga concentration is 15 atomic percent or less with respect to Zn, preferably 0.02 to 10 atomic percent, and more preferably 0.5 to 2 atomic percent. The Ga concentration is determined thus for the same reason as described in the first embodiment.

The pressure in the DC sputtering apparatus is preferably about 0.6 Pa, the temperature of the electrically insulating transparent substrate 11 is preferably from normal room temperature to 135°C, and the sputtering power is preferably about 100 W.

Also with the transparent conductive interlayer 61 formed as described above, the same advantages as the tandem photovoltaic device according to the fifth embodiment can be offered.

The tandem photovoltaic device according to the sixth embodiment includes electricity-generating layers made of amorphous silicon and electricity-generating layers made of microcrystalline silicon. Alternatively, the tandem photovoltaic device according to the present invention may include electricity-generating layers made of one type of microcrystalline silicon and electricity-generating layers made of another type of microcrystalline silicon with different spectral sensitivities. Furthermore, the tandem photovoltaic device according to the present invention may include electricity-generating layers made of microcrystalline silicon and electricity-generating layers made of microcrystalline silicon germanium with different spectral sensitivities.

Microcrystalline silicon germanium can be produced from SiH₄, GeH₄, and H₂ serving as raw materials in the same manner as for microcrystalline silicon.

### EXAMPLES

Examples according to the present invention will now be described below.

### EXAMPLE 1

A photovoltaic device according to Example 1 was produced based on the first embodiment. More specifically, as shown in Fig. 1, the photovoltaic device according to Example 1 is a single photovoltaic device including microcrystalline-silicon electricity-generating layers 13, 14, and 15, where incident light enters via the electrically insulating transparent substrate 11.

In the first and second transparent electrodes 12 and 16, the Ga concentration was 1 atomic percent with respect to Zn.

The film thickness of the first and second transparent electrodes 12 and 16 was 80 nm.

The transmittance of the above-described transparent electrodes was 95% or higher in a wavelength range of 550 nm or more.

For a comparative example, a photovoltaic device the same as that according to Example 1, except for a Ga concentration of 9 atomic percent, was also produced.

### EXAMPLE 2

A photovoltaic device according to Example 2 was produced based on the third embodiment. More specifically, as shown in Fig. 3, the photovoltaic device according to Example 2 is a single photovoltaic device including amorphous-silicon electricity-generating layers 33, 34, and 35, where incident light enters via the electrically insulating transparent substrate 11.

In the second transparent electrode 36, the Ga concentration was 1 atomic percent with respect to Zn.

The film thickness of the second transparent electrode 36 was 80 nm.

The transmittance of the above-described transparent electrode was 95% or higher in a wavelength range of 550 nm or more.

For a comparative example, a photovoltaic device the same as that according to Example 2, except for a Ga concentration of 9 atomic percent, was also produced.

### EXAMPLE 3

A photovoltaic device according to Example 3 was produced based on the fifth embodiment. More specifically, as shown in Fig. 5, the photovoltaic device according to Example 3 is a tandem photovoltaic device including amorphous-silicon electricity-generating layers 33, 34, and 35 and microcrystalline-silicon electricity-generating layers 13, 14, and 15, where incident light enters via the electrically insulating transparent substrate 11.

In the second transparent electrode 16, the Ga concentration was 1 atomic percent with respect to Zn.

The film thickness of the second transparent electrode 16 was 80 nm.

The transmittance of the above-described transparent electrode was 95% or higher in a wavelength range of 550 nm or more.

For a comparative example, a photovoltaic device the same as that according to Example 3, except for a Ga concentration of 9 atomic percent, was also produced.

### EXAMPLE 4

A photovoltaic device according to Example 4 was produced based on the sixth embodiment. More specifically, as shown in Fig. 6, the photovoltaic device according to Example 4 is a tandem photovoltaic device including the transparent conductive interlayer 61 between the amorphous-silicon electricity-generating layers 33 to 35 and the microcrystalline-silicon electricity-generating layers 13 to 15, where incident light enters via the electrically insulating transparent substrate 11.

In the second transparent electrode 16 and the transparent conductive interlayer 61, the Ga concentration was 1 atomic percent with respect to Zn.

The film thickness of the second transparent electrode 16 was 80 nm.

The film thickness of the transparent conductive interlayer 61 was 50 nm.

The transmittance of the above-described transparent electrode was 95% or higher in a wavelength range of 550 nm or more.

For a comparative example, a photovoltaic device the same as that according to Example 4, except for a Ga concentration of 9 atomic percent, was also produced.

The electric power generation performance of the photovoltaic devices produced based on Examples 1 to 4 and the respective comparative examples was evaluated by irradiating the electrically insulating transparent substrate 11 of each photovoltaic device with a solar simulator (spectral type: AM 1.5; irradiation intensity: 100 mW/m²; irradiation temperature: 25°C). The results are shown in Table 1.

**TABLE 1**

| | Example 1 (microcrystalline Si, single) | | Example 2 (a-Si, single) | | Example 3 (tandem, without interlayer) | | Example 4 (tandem, with interlayer) | |
|---|---|---|---|---|---|---|---|---|
| | comp. example | invention | comp. example | invention | comp. example | invention | comp. example | invention |
| Ga (at.%) | 9 | 1 | 9 | 1 | 9 | 1 | 9 | 1 |
| Jsc | 1 | 1.1 | 1 | 1.05 | 1 | 1.05 | 1 | 1.08 |
| Voc | 1 | 1 | 1 | 1 | 1 | 1 | 1 | 1 |
| FF | 1 | 1 | 1 | 1 | 1 | 1.02 | 1 | 1.02 |
| Eff. | 1 | 1.08 | 1 | 1.02 | 1 | 1.03 | 1 | 1.05 |

In Table 1, the short-circuit current density (Jsc), open-circuit voltage (Voc), and fill factor (FF) of each photovoltaic device are shown as relative values, which are normalized with respect to the measured values of the corresponding comparative example (i.e., a measured value of the corresponding comparative example is regarded as 1.0).

As is apparent from Table 1, decreasing the Ga concentration causes high transmittance to be realized over a wide range of wavelengths, which enables the photovoltaic layers to receive more intense light to increase the short-circuit current density (Jsc).

For the tandem photovoltaic devices according to Examples 3 and 4, a decrease in the Ga concentration causes the crystallinity of the p-type silicon layers to be enhanced and the fill factor (FF) to be improved.

With these improvements in the short-circuit current density (Jsc) and fill factor (FF), decreasing the Ga concentration in the transparent electrodes or transparent conductive interlayer made of Ga-doped ZnO leads to an increase in the conversion efficiency.

In particular, the single photovoltaic device including microcrystalline silicon according to Example 1 exhibits a significant improvement in the conversion efficiency (Eff.). This is because the decrease in the amount of Ga causes the quality of the interface between the Si layer (p layer or n layer) and the ZnO:Ga layer to be improved.

## Claims

1. A photovoltaic device comprising:
an electrically insulating transparent substrate;
a first transparent electrode;
PIN-structured or NIP-structured microcrystalline silicon layers including a p-type silicon layer, an i-type silicon layer, and an n-type silicon layer;
a second transparent electrode; and
a back electrode,
wherein the first transparent electrode, the PIN-structured or NIP-structured microcrystalline silicon layers, the second transparent electrode, and the back electrode are deposited in sequence on the electrically insulating transparent substrate; and
wherein at least one of the first transparent electrode and the second transparent electrode is a ZnO layer doped with Ga, and the Ga concentration is 15 atomic percent or less with respect to Zn.

2. A photovoltaic device comprising:
an electrically insulating substrate;
a back electrode;
a first transparent electrode;
PIN-structured or NIP-structured microcrystalline silicon layers including a p-type silicon layer, an i-type silicon layer, and an n-type silicon layer;
a second transparent electrode; and
a collecting electrode,
wherein the back electrode, the first transparent electrode, the PIN-structured or NIP-structured microcrystalline silicon layers, the second transparent electrode, and the collecting electrode are deposited in sequence on the electrically insulating substrate; and
wherein at least one of the first transparent electrode and the second transparent electrode is a ZnO layer doped with Ga, and the Ga concentration is 15 atomic percent or less with respect to Zn.

3. A photovoltaic device comprising:
an electrically insulating transparent substrate;
a first transparent electrode;
PIN-structured or NIP-structured amorphous silicon layers including a p-type silicon layer, an i-type silicon layer, and an n-type silicon layer;
a second transparent electrode; and
a back electrode,
wherein the first transparent electrode, the PIN-structured or NIP-structured amorphous silicon layers, the second transparent electrode, and the back electrode are deposited in sequence on the electrically insulating transparent substrate; and
wherein at least one of the first transparent electrode and the second transparent electrode is a ZnO layer doped with Ga, and the Ga concentration is 2 atomic percent or less with respect to Zn.

4. A photovoltaic device comprising:
an electrically insulating substrate;
a back electrode;
a first transparent electrode;
PIN-structured or NIP-structured amorphous silicon layers including a p-type silicon layer, an i-type silicon layer, and an n-type silicon layer;
a second transparent electrode; and
a collecting electrode,
wherein the back electrode, the first transparent electrode, the PIN-structured or NIP-structured amorphous silicon layers, the second transparent electrode, and the collecting electrode are deposited in sequence on the electrically insulating substrate; and
wherein at least one of the first transparent electrode and the second transparent electrode is a ZnO layer doped with Ga, and the Ga concentration is 2 atomic percent or less with respect to Zn.

5. The photovoltaic device according to claim 1, further comprising:
PIN-structured or NIP-structured amorphous silicon layers disposed between the first transparent electrode or the second transparent electrode and the PIN-structured or NIP-structured microcrystalline silicon layers.

6. The photovoltaic device according to claim 2, further comprising:
PIN-structured or NIP-structured amorphous silicon layers disposed between the first transparent electrode or the second transparent electrode and the PIN-structured or NIP-structured microcrystalline silicon layers.

7. The photovoltaic device according to claim 5, further comprising:
a transparent conductive interlayer disposed between the amorphous silicon layers and the microcrystalline silicon layers,
wherein the transparent conductive interlayer is a ZnO layer doped with Ga, and the Ga concentration is 15 atomic percent or less with respect to Zn.

8. The photovoltaic device according to claim 6, further comprising:
a transparent conductive interlayer disposed between the amorphous silicon layers and the microcrystalline silicon layers,
wherein the transparent conductive interlayer is a ZnO layer doped with Ga, and the Ga concentration is 15 atomic percent or less with respect to Zn.

9. The photovoltaic device according to claim 1, further comprising:
other PIN-structured or NIP-structured microcrystalline silicon layers having a different spectral sensitivity or microcrystalline silicon germanium layers having a different spectral sensitivity disposed between the first transparent electrode or the second transparent electrode and the PIN-structured or NIP-structured microcrystalline silicon layers.

10. The photovoltaic device according to claim 2, further comprising:
other PIN-structured or NIP-structured microcrystalline silicon layers having a different spectral sensitivity or microcrystalline silicon germanium layers having a different spectral sensitivity disposed between the first transparent electrode or the second transparent electrode and the PIN-structured or NIP-structured microcrystalline silicon layers.

11. The photovoltaic device according to claim 9, further comprising:
a transparent conductive interlayer disposed between the microcrystalline silicon layers and the other PIN-structured or NIP-structured microcrystalline silicon layers having a different spectral sensitivity or the microcrystalline silicon germanium layers having a different spectral sensitivity,
wherein the transparent conductive interlayer is a ZnO layer doped with Ga, and the Ga concentration is 15 atomic percent or less with respect to Zn.

12. The photovoltaic device according to claim 10, further comprising:
a transparent conductive interlayer disposed between the microcrystalline silicon layers and the other PIN-structured or NIP-structured microcrystalline silicon layers having a different spectral sensitivity or the microcrystalline silicon germanium layers having a different spectral sensitivity,
wherein the transparent conductive interlayer is a ZnO layer doped with Ga, and the Ga concentration is 15 atomic percent or less with respect to Zn.
